(19) Europäisches Patentamt
European Patent Office
Office européen des brevets

(11) Veröffentlichungsnummer: **0 230 300 B1**

# (12) EUROPÄISCHE PATENTSCHRIFT

(45) Veröffentlichungstag der Patentschrift: **07.11.90**

(51) Int. Cl.[5]: **G03F 7/032**

(21) Anmeldenummer: **87100674.8**

(22) Anmeldetag: **20.01.87**

(54) **Durch Photopolymerisation vernetzbare Gemische.**

(30) Priorität: **22.01.86 DE 3601802**

(43) Veröffentlichungstag der Anmeldung: **29.07.87 Patentblatt 87/31**

(45) Bekanntmachung des Hinweises auf die Patenterteilung: **07.11.90 Patentblatt 90/45**

(84) Benannte Vertragsstaaten: **BE CH DE FR GB IT LI NL SE**

(56) Entgegenhaltungen: **DE-A- 2 723 905**

(73) Patentinhaber: **BASF Aktiengesellschaft, Carl-Bosch-Strasse 38, D-6700 Ludwigshafen(DE)**

(72) Erfinder: **Richter, Peter, Dr., Bensheimer Ring 24, D-6710 Frankenthal(DE)**
Erfinder: **Hoffmann, Gerhard, Dr., Pappelstrasse 22, D-6701 Otterstadt(DE)**
Erfinder: **Bronstert, Klaus, Dr., Gartenstrasse 26, D-6719 Carlsberg(DE)**
Erfinder: **Müller, Wolfgang, Dr., Im Biengarten 45, D-6730 Neustadt(DE)**
Erfinder: **Gerberding, Karl, Dr., In der Dreispitz 9, D-6706 Wachenheim(DE)**

EP 0 230 300 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Die Erfindung betrifft durch Photopolymerisation vernetzbare Gemische mit verbesserten Verarbeitungseigenschaften auf der Grundlage von Bindemitteln, hiermit verträglichen photopolymerisierbaren Monomeren, Photoinitiatoren und Inhibitoren gegen die thermisch initiierte Polymerisation, die als Bindemittel Polymerisate der Formel I enthalten,

$$[Pol-\!\!(R^1-O)_a-\overset{\overset{O}{\|}}{C}-R^2-X^{\ominus}]_n\ [M]^{n\oplus} \qquad I$$

worin die Variablen und die Indices folgende Bedeutung haben:
Pol Rest eines durch sequentielle anionische Polymerisation von konjugierten Dienen und Vinylaromaten hergestellten Blockcopolymerisats,
$R^1$ vicinale Alkan-diyl-Gruppe,
$R^2$ zweiwertige Kohlenwasserstoffgruppe mit 2 bis 20 Kohlenstoffatomen,
$X^{\ominus}$ Säureanion-Gruppe,
M Metallkation, Metallkationenkomplex oder Kation eines Amins und
a eine ganze Zahl von 1 bis 10 und
n eine ganze Zahl von 1 bis 10.

Außerdem betrifft die Erfindung die Verwendung solcher Gemische für die Herstellung von Druckplatten, Reliefplatten und photovernetzbaren Filmen, von lichthärtbaren Klebern, Dichtungsmassen und Lacken sowie von kautschukelastischen Druckformen, Reliefformen und photovernetzten Folien mit verbesserten anwendungstechnischen Eigenschaften.

Des weiteren betrifft die Erfindung nicht kriechende Druckplatten, Reliefplatten und photovernetzbare Filme, lichthärtbare Kleber, Dichtungsmassen und Lacke sowie kautschukelastische Druckformen, Reliefformen und photovernetzte Folien, die unter Verwendung der erfindungsgemäßen Gemische hergestellt werden.

Durch Photopolymerisation vernetzbare Gemische, die neben Monomeren, Photoinitiatoren und Inhibitoren gegen die thermisch initiierte Polymerisation Blockcopolymerisate entsprechend dem Molekülteil "Pol" von I enthalten, sind aus der DE-OS 24 56 439 bekannt. Feste niedrigviskose Gemische dieser Art neigen jedoch im unvernetzten Zustand zum Kriechen, und Druckformen auf dieser Basis weisen eine unbefriedigende Kautschukelastizität auf. Feste höherviskose Gemische, auf deren Grundlage sich Druckformen guter Kautschukelastizität herstellen ließen, sind jedoch in Entwicklerlösungsmitteln schlecht löslich und zudem schwer zu verarbeiten.

Solche Gemische sind daher für eine Anwendung auf dem Druckformen-, Reliefformen-, Folien-, Klebmittel-, Dichtungsmassen- oder Lacksektor weniger geeignet.

Aufgabe der Erfindung war es, neue, durch Photopolymerisation vernetzbare Gemische zu finden, die sich für die Herstellung von Druckplatten, Reliefplatten und photovernetzbaren Filmen sowie von lichthärtbaren Klebern, Dichtungsmassen und Lacken eignen, eine sehr geringe Kriechneigung zeigen und sich leicht verarbeiten lassen.

Außerdem war es Aufgabe der Erfindung, Gemische zu finden, die sich für die Herstellung von kautschukelastischen Druckformen, Reliefformen und photovernetzten Folien eignen.

Nicht zuletzt war es Aufgabe der Erfindung, neue nicht kriechende Druckplatten, Reliefplatten und photovernetzbare Filme, lichthärtbare Kleber, Dichtungsmassen und Lacke sowie kautschukelastische Druckformen, Reliefformen und photovernetzte Folien zu finden.

Demgemäß wurden durch Photopolymerisation vernetzbare nicht kriechende Gemische auf der Grundlage von Bindemitteln, hiermit verträglichen photopolymerisierbaren Monomeren, Photoinitiatoren und Inhibitoren gegen die thermisch initiierte Polymerisation gefunden, die als Bindemittel die eingangs definierten Polymerisate I enthalten.

Außerdem wurde gefunden, daß sich solche Gemische hervorragend für die Herstellung von nicht kriechenden Druckplatten, Reliefplatten und photovernetzbaren Filmen, von lichthärtbaren Klebern, Dichtungsmassen und Lacken sowie von kautschukelastischen Druckformen, Reliefformen und photovernetzten Folien eignen.

Des weiteren wurden nicht kriechende Druckplatten, Reliefplatten und photovernetzbare Filme, lichthärtbare Kleber, Dichtungsmassen und Lacke sowie kautschukelastische Druckformen, Reliefformen und photovernetzte Folien, die unter Verwendung der erfindungsgemäßen Gemische hergestellt werden, gefunden.

Polymerisate I mit $X^{\ominus}$ = Carboxylat, M = Li und n = 1 sind aus der DE-OS 27 23 905 bekannt. Sie werden hergestellt durch a) sequentielle anionische Polymerisation von Vinylaromaten und von konjugierten Dienen mit Lithiumalkylen als Initiatoren, b) Umsetzung der "lebenden" Carbanionen an den Kettenenden mit Alkylenoxiden unter Bildung polymerer Lithiumalkoholate und c) Teilveresterung dieser Alkoholate mit Dicarbonsäureanhydriden.

Geeignet als "Pol" sind Blockcopolymerisat-Reste der Formel II

$$-(-A\text{-}B-)-_m \qquad II$$

worin m eine ganze Zahl zwischen 1 und 4, A einen Homopolymerisatblock aus Vinylaromaten oder einen Copolymerisatblock aus Vinylaromaten und konjugierten Dienen und B einen Homo- oder Copolymerisatblock aus konjugierten Dienen oder einen Copolymerisatblock aus konjugierten Dienen und Vinylaromaten bezeichnet.

Vorteilhaft sind Blockcopolymerisat-Reste II mit m = 1 und einem Anteil an Blöcken B von, bezogen auf A+B, 60 bis 97, vorzugsweise 70 bis 95 und insbesondere 75 bis 90 Gew.%.

Vorteilhaft sind Blöcke A mit einer Glastemperatur Tg von mehr als 20°C. Diese Blöcke können im allgemeinen eine Molmasse von 1.500 bis 150.000, vorzugsweise 5.000 bis 100.000 und insbesondere 5.000 bis 50.000 aufweisen. Sie können untergeordnete Mengen an konjugierten Dienen einpolymerisiert enthalten.

Vorteilhaft sind Blöcke B mit einer Glastemperatur Tg unterhalb 20°C, vorzugsweise unterhalb 0°C und insbesondere unterhalb -15°C. Diese Blöcke können im allgemeinen eine Molmasse von 1000 bis 200.000, vorzugsweise 15.000 bis 150.000 und insbesondere 20.000 bis 100.000 aufweisen. Sie können untergeordnete Mengen an Vinylaromaten einpolymerisiert enthalten, und ihre olefinischen Doppelbindungen können partiell oder vollständig hydriert sein.

Beispiele für geeignete konjugierte Diene sind Butadien, Isopren, Pentan-1,3-dien, 2,3-Dimethylbutadien oder Hexan-2,4-dien, von denen Butadien und Isopren bevorzugt sind.

Beispiele für geeignete Vinylaromaten sind Styrol, α-Methylstyrol, p-Methylstyrol, p-tert.-Butylstyrol oder 1-Vinylnaphthalin, von denen Styrol bevorzugt ist.

Beispiele für vorteilhafte vicinale Alkan-diylgruppen $R^1$ sind Ethylen-, Propan-1,2-ylen, Phenylethylen-, Butan-1,2-ylen-, Butan-2,3-ylen, Cyclopent-1,2-ylen-, Cyclohex-1,2-ylen- oder 3-Hydroxi-propan-1,2-ylen-Gruppen, von denen die ersten drei bevorzugt sind. Diese Gruppen leiten sich ab von den entsprechenden Epoxiden. Sie können mit dem Block A oder dem Block B - vorteilhafterweise aber mit dem Block B - verbunden sein. Es ist dabei ferner von Vorteil, wenn a eine ganze Zahl von 1 bis 5, insbesondere von 1 bis 3 ist.

Beispiele für geeignete zweiwertige Kohlenwasserstoffgruppen $R^2$ mit 2 bis 20 Kohlenstoffatomen sind Alkandiyl-, Alkendiyl-, Alkadiendiyl-, Cycloalkylen-, Cycloalkenylen- oder Arylengruppen, wobei Ethylen-, Trimethylen-, Propen-2,3-diyl-, Buta-1,3-dien-2,3-diyl-, Cyclohex-1,2-ylen-, Cyclohexa-3-en-1,6-ylen-, Cyclopent-1,2-ylen-, o-Phenylen- oder Naphth-1,8-diyl-Gruppen von besonderem Vorteil sind.

Beispiele für geeignete Gruppen $X^\ominus$ sind Carboxylat-, Phosphonat- oder Sulfonatgruppen, von denen Carboxylat- und Sulfonatgruppen vorteilhaft und Carboxylatgruppen besonders vorteilhaft sind.

Geeignete Metallkationen M sind Kationen der Alkali- und Erdalkalimetalle der Metalle der Lanthanidenreihe, der I. bis VIII. Nebengruppe oder der III. bis V. Hauptgruppe des Periodischen Systems der Elemente. Von besonderem Vorteil sind $Li^\oplus$, $Zn^{2\oplus}$ und $Al^{3\oplus}$, wobei dann n von I gleich 1, 2 oder 3 ist.

Beispiele für geeignete Metallkationenkomplexe M sind $TiO^{2\oplus}$, $VO_2^\oplus$ oder Kationenkomplexe der Formel III,

$$[Me\text{-}O\text{-}(\text{-}Me(OR^3)_2\text{-}O\text{-})_r\text{-}Me]^{4\oplus} \qquad III$$

worin Me gleich $Al^{3\oplus}$ oder $Cr^{3\oplus}$, r gleich 0 oder einer ganzen Zahl von 1 bis 20, vorzugsweise 0 oder 1 bis 10 und $R^3$ gleich einem Wasserstoffatom oder einem Alkylrest mit 1 bis 4 C-Atomen ist, wobei Komplexe III mit Me = $Al^{3\oplus}$, r = 2 bis 5 und $R^3$ = Methyl von Vorteil sind.

Beispiele für geeignete Kationen M von Aminen sind solche der Formel IV oder V,

$$[NR^4R^5R^6R^7]^\oplus \qquad IV$$
$$[R^4R^5R^6R^7N^\oplus\text{-}R^2\text{-}N^\oplus R^4R^5R^6R^7] \qquad V$$

worin $R^2$ die bei der Formel I angegebene Bedeutung besitzt und worin $R^4$, $R^5$, $R^6$ und $R^7$ Wasserstoffatome, verzweigte und unverzweigte Alkylreste, Cycloalkylreste, gegebenenfalls substituierte Arylreste oder Arylalkylreste darstellen, z.B. Ammonium-, Dimethylammonium-, Trimethylammonium-, Ethylammonium-, Diethylammonium-, Triethylammonium-, Tetraethylammonium-, Methylethylammonium-, Di-n-butylammonium-, Dimethyl-di-n-butylammonium-, Cyclohexylammonium-, Dicyclohexylammonium-, Cyclohexyltrimethylammonium-, Trimethyloctylammonium-, Trimethylundecylammonium-, tert.-Butylammonium-, Neopentylammonium-, Phenyldimethyl-p-tolyl-dimethylammonium-, p-Methoxiphenyl-diethylammonium-, Benzylammonium-, Dibenzylammonium-, 2-Phenylethylammonium-, Dimethyl-bis-(2-phenylethyl)ammonium-, Ethylendiammonium-, Propylendiammonium-, N,N,N',N'-Tetramethylethylendiammonium-, N,N'-Diethyl-o-phenylendiammonium-, N,N,N',N'-Tetra-n-butyl-cyclohex-1,4-ylendiammonium oder N,N,N',N'-Tetramethyl-[methylen-bis(cyclohex-1,4-ylen)]-diammoniumionen. Außerdem sind Ammoniumionen aliphatischer Heterocyclen geeignet, z.B. die Ammoniumionen von Pyrrolidin, Piperidin, Imidazolidin, Piperazin, Isoindolin, Chinuclidin oder von Morpholin. Von Vorteil sind die Ammoniumionen des Ethylendiamins und des N,N,N',N'-Tetramethylethylendiamins.

Erfindungsgemäß mit besonderem Vorteil anzuwendende flüssige Polymerisate I besitzen Molmassen von 2.000 bis 20.000, insbesondere 4000 bis 15.000 (bestimmt durch Gelpermeationschromatographie).

Erfindungsgemäß mit besonderem Vorteil anzuwendende feste Polymerisate I besitzen Molmassen von 20.000 bis 100.000, bevorzugt 40.000 bis 90.000 und insbesondere 50.000 bis 85.000. Vorteilhafterweise weisen sie eine Viskositätszahl VZ von 70 bis 300, bevorzugt 80 bis 250 und insbesondere 110 bis 200 ml/g auf. Außerdem ist es von Vorteil, wenn sie eine Deformationshärte von 2.000 bis 30.000, bevorzugt 2.500 bis 25.000 und insbesondere 2.700 bis 10.000 (bestimmt nach DIN 53 514), eine Deformationselastizität von 25 bis 65, bevorzugt 30 bis 60 und insbesondere 30 bis 57 (bestimmt nach DIN 53 514) sowie eine Shore A-Härte von 10 bis 80, bevorzugt 15 bis 70 und insbesondere 15 bis 65 (bestimmt nach DIN 53 505) aufweisen.

Die erfindungsgemäß anzuwendenden Polymerisate I werden vorzugsweise in einer Menge von 40 bis 99, vorteilhafterweise 60 bis 97 und insbesondere 70 bis 96 Gew.%, bezogen auf ein erfindungsgemäßes Gemisch aus Bindemittel, Monomer, Initiator und Inhibitor, verwendet.

Geeignete verträgliche photopolymerisierbare Monomere sollen vorzugsweise einen Siedepunkt höher als 100°C aufweisen. Beispiele für geeignete Monomere sind die Ester der Acrylsäure und/oder Methacrylsäure mit ein- oder mehrwertigen Alkoholen, die 2 bis 20 Kohlenstoffatome aufweisen, z.B. Butylacrylat, Butylmethacrylat, 2-Ethylhexylacrylat, Lauryl(meth)acrylat, Ethylenglykol-di(meth)acrylat, Butandiol-1,4-di(meth)acrylat, Neopentylglykol-di(meth)acrylat, 3-Methylpentandiol-di(meth)acrylat, 2-Hydroxipropyl(meth)acrylat, 2-Hydroxiethyl(meth)acrylat, Hexandiol-1,6-di(meth)acrylat, 1,1,1-Trimethylolpropantri(meth)acrylat, Di-, Tri- und Tetraethylenglykoldi(meth)acrylat, Tripropylenglykol-di(meth)acrylat oder Pentaerythrit-tetra(meth)acrylat. In Frage kommen ferner die Vinylester aliphatischer Monocarbonsäuren, z.B. Vinyloleat; die Vinylether von Alkoholen, z.B. Octadecylvinylether und Butandiol-1,4-divinylether; die Diester von Fumar- und Maleinsäure; oder die Umsetzungsprodukte aus OH-terminierten, Oligobutadienen mit Maleinsäure und/oder (Meth)Acrylsäure. In den erfindungsgemäßen Gemischen werden sie - vorzugsweise einzeln oder als Mischung - in einer Menge von 1 bis 40, vorteilhafterweise 2 bis 30 und insbesondere 3 bis 20 Gew.%, bezogen auf ein erfindungsgemäßes Gemisch aus Bindemittel, Monomer, Initiator und Inhibitor, verwendet.

Beispiele für geeignete verträgliche Photoinitiatoren sind Benzoin oder Benzoinderivate wie dessen Methyl-, Isopropyl-, n-Butyl- oder Isobutylether; symmetrisch oder unsymmetrisch substituierte Benzilacetale wie Benzildimethylacetal, Benzil-1-methyl-1-ethyl-acetal; Acyldiarylphosphinoxide und Acylarylphosphinsäurederivate wie 2,6-Dimethoxibenzoyl-diphenylphosphinoxid, 2,4,6-Trimethylbenzoyl-diphenylphosphinoxid, 2,4,6-Trimethylbenzoyl-phenylphosphinsäure-Natriumsalz oder 2,4,6-Trimethylbenzoyl-phenylphosphinsäureethylester; oder substituierte und unsubstituierte Chinone wie Ethylanthrachinon, Benzanthrachinon, Benzophenon oder 4,4'-Bis(dimethylamino)benzophenon. Sie können allein oder im Gemisch miteinander verwendet werden. In den erfindungsgemäßen Gemischen werden sie vorzugsweise in einer Menge von 0,01 bis 10, vorteilhafterweise 0,1 bis 8 und insbesondere 0,5 bis 5 Gew.%, bezogen auf ein erfindungsgemäßes Gemisch aus Bindemittel, Monomer, Initiator und Inhibitor, verwendet, wobei die Menge mitbestimmt wird von der Menge an mitverwendeten photopolymerisierbaren Monomeren.

Geeignete Inhibitoren gegen die thermisch initiierte Polymerisation zeigen im allgemeinen keine nennenswerte Eigenabsorption in dem aktinischen Bereich, in dem der Photoinitiator absorbiert. Beispiele für geeignete Inhibitoren sind Hydrochinon, p-Methoxiphenol, 2,6-Di-tert.-butyl-p-kresol, β-Naphthol, Phenothiazin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040); oder N-Nitrosamine, wie N-Nitrosodiphenylamin, oder die Salze, beispielsweise die Kalium-, Calcium-, Cer- oder Aluminiumsalze, des N-Nitrosocyclohexylhydroxylamins. Sie werden vorzugsweise in Mengen von 0,001 bis 2, bevorzugt 0,01 bis 1,8 und insbesondere 0,1 bis 1,5 Gew.%, bezogen auf ein erfindungsgemäßes Gemisch aus Bindemittel, Monomer, Initiator und Inhibitor, verwendet.

Die erfindungsgemäßen Gemische können ferner noch weitere Zusatzstoffe enthalten.

Dazu zählen beispielsweise Weichmacher, Antiozonantien, Farbstoffe, Pigmente, photochrome Zusätze, Reduktionsmittel, Mittel zur Verbesserung der Reliefstruktur, Antioxidantien, Füllstoffe, Verstärkerfüllstoffe, Flußmittel, Formtrennmittel, Vernetzungshilfsmittel, klebrigmachende Harze und Kautschuke, die für sich alleine oder als Gemische in Mengen von bis zu 100 Gew.-Teilen auf 100 Gew.-Teile an erfindungsgemäßem Gemisch, zugesetzt werden können.

Die Herstellung der erfindungsgemäßen Gemische aus den Komponenten weist keine methodischen Besonderheiten auf; es können z.B. die üblichen Knet-, Misch- und Lösungstechniken angewendet werden.

Die so erhaltenen erfindungsgemäßen Gemische können direkt als lichthärtbare Kleber, Dichtungsmassen und Lacke verwendet oder zu photovernetzbaren Filmen, Druckplatten und Reliefplatten weiterverarbeitet werden. Dazu werden sie in üblicher Weise z.B. durch Gießen aus einer Lösung, Heißpressen, Kalandrieren oder Extrudieren zu Flächengebilden der gewünschten Dicke geformt. Diese richtet sich im Falle der Platten in erster Linie nach dem späteren Verwendungszweck und variiert im allgemeinen von 0,01 bis 7, insbesondere von 0,025 bis 6,5 mm, da beispielsweise daraus hergestellte Druckformen dieser Dicke für die Mehrzahl der Drucktechniken geeignet sind. Im Falle der Filme ist die Dicke beliebig.

Die Flächengebilde können als solche zu Druckformen, Reliefformen und photovernetzten Folien verarbeitet werden; es ist jedoch üblich, sie im Verbund mit anderen schichtenförmigen Materialien herzustellen und dann erst weiterzuverarbeiten. Ein solcher Verbund wird allgemein als "Mehrschichtenelement" und das darin enthaltene Flächengebilde im Falle von Druckplatten und Reliefplatten, als reliefbildende Schicht "RS" im anderen Fall als photovernetzbarer Film "PF" bezeichnet.

Üblicherweise ist in einem solchen Mehrschichtenelement "RS" oder "PF" mit einem dimensionsstabilen Träger "T" haftfest verbunden. "T" wiederum kann mit einer weichelastischen Unterschicht unterlegt sein. Desweiteren kann auf die von "T" abgewandte Seite von "RS" oder von "PF" eine Deckschicht "DS" und/oder eine Deckfolie "DF" aufgebracht werden. Werden "DS" und "DF" gemeinsam verwendet, dann liegt "DS" der Schicht "RS" direkt auf, und es kann sich zwischen "DS" und "DF" noch eine Antihaftschicht "AS" befinden. Ferner kann eine haftfeste Verbindung zwischen "T" und "RS" oder "PF" und gegebenenfalls "RS" oder "PF" und "DF" mit Hilfe einer Haftschicht "HS" erreicht werden.

Als "T" können im allgemeinen Platten, Folien oder konische Röhren (sleeves) aus Metallen wie Stahl, Aluminium, Kupfer oder Nickel oder aus Kunststoffen wie Polyethylenterephthalat, Polybutylenterephthalat, Polyamid oder Polycarbonat verwendet werden. Daneben kommen noch Gewebe und Vliese, z.B. Glasfasergewebe oder Verbundmaterialien aus z.B. Glasfasern und Kunststoffen wie Polyethylenterephthalat in Frage.

Als "HS" können im allgemeinen etwa 0,5 bis 40 µm dicke Haftlackschichten aus üblichen Reaktionsklebern auf Polyurethan-, Polychloropren- oder Phenoxiharz/Polycarbonat-Basis verwendet werden.

Als "DS" können im allgemeinen etwa 0,5 bis 20 µm dicke Schichten aus einem Polymeren, das lösliche, klebfreie, transparente und reißfeste Filme bildet, verwendet werden. In Frage kommen z.B. Polyamid, Copolyamid, Polyurethan, Polyvinylalkohol, Polyvinylpyrrolidon, Polyethylenoxid oder Cyclokautschuk mit einem hohen Cyclisierungsgrad. Gegebenenfalls kann "DS" mattiert sein.

Als "DF" können im allgemeinen etwa 20 bis 150 µm dicke Schichten aus einem Polymeren wie Polyamid oder Polyethylenterephthalat verwendet werden.

Als "AS" können im allgemeinen etwa 0,1 bis 0,5 µm dicke Schichten aus beispielsweise Silikonharzen verwendet werden.

Werden als "T" stark reflektierende Platten oder Folien verwendet, dann können sie geeignete Lichthofschutzmittel, d.h. Substanzen mit hohem Extinktionskoeffizienten, wie Ruß, Mangandioxid oder Auraminfarbstoffe, die ggf. als Mischung mit Benzophenonderivaten vorliegen, enthalten. Die Lichthofschutzmittel können aber auch als separate Schicht auf "T" aufgetragen werden oder in "HS" oder "RS" enthalten sein.

Die Herstellung solcher Mehrschichtenelemente weist keine methodischen Besonderheiten auf und kann durch Auftragen von "RS" oder "PF" auf "T" z.B. mittels Gießen aus Lösung, Heißpressen, Kalandrieren oder Extrudieren erfolgen. Auf dieses Zweischichtenelement können dann die anderen Schichten in bekannter Weise aufgebracht werden. Es ist aber auch möglich, "RS" oder "PF" zuerst auf die mit "DS" bedeckte Seite von "DF" aufzutragen und anschließend die unbedeckte Seite von "RS" mit "T" haftfest zu verbinden.

Aus den Flächengebilden, die aus den erfindungsgemäßen Gemischen bestehen, oder aus den Mehrschichtenelementen, die solche Flächengebilde aus den erfindungsgemäßen Gemischen enthalten, können durch vollflächige Belichtung photovernetzte Folien und durch bildmäßige Belichtung Druckformen und Reliefformen hergestellt werden. Beides bietet keine methodischen Besonderheiten. In beiden Fällen kann die Belichtung mit aktinischem Licht einer Wellenlänge $\lambda$ von 230 bis 450, vorteilhafterweise 300 bis 450 nm erfolgen. Im Falle der bildmäßigen Belichtung schließen sich das Auswaschen der unbelichteten und daher unvernetzten Anteile der Flächengebilde (Entwickeln), das Trocknen der so erhaltenen Druckformen und Reliefformen und gegebenenfalls deren Nachbehandeln an.

Geeignete Lichtquellen für aktinisches Licht sind z.B. die Strahlung der Sonne oder handelsübliche UV-Fluoreszenzröhren, Quecksilbermittel-, -hoch- und -niederdruckstrahler, superaktinische Leuchtstoffröhren, Xenonimpulslampen, mit Metalliodiden dotierte Lampen oder Kohlebogenlampen.

Geeignete Entwicklerlösungsmittel sind aromatische Kohlenwasserstoffe, z.B. Toluol oder Ethylbenzol; Chlorkohlenwasserstoffe, z.B. 1,1,1-Trichlorethan, 1,1,2,2-Tetrachlorethan oder Tetrachlorethylen; Ketone, z.B. Methylisobutylketon; oder Mischungen solcher Lösungsmittel miteinander oder mit niederen Alkoholen, z.B. n-Butanol.

Die Dicke von "RS" der Druckformen und Reliefformen variiert je nach Anwendungszweck von 0,01 bis 7 mm, von Vorteil sind Dicken von 0,025 bis 6,5 mm.

Die in dieser Weise erhaltenen Druckformen auf der Grundlage der erfindungsgemäßen Gemische können auf Druckzylinder aufgebracht, gegebenenfalls durch Coronaentladungen aufgerauht und für den Endlosdruck verwendet werden.

In den folgenden Beispielen wurde die Shore A-Härte nach DIN 53 505, die Rückprallelastizität nach DIN 53 512, die Reißdehnung nach DIN 53 504 an Prüfkörpern S2, die Deformationshärte und die Deformationselastizität nach DIN 53 514 und die Viskositätszahl VZ nach DIN 51 562 an Polymerlösungen aus 0,5 g I und 120 ml Toluol bestimmt. Die Molmasse wurde durch Gelpermeationschromatographie ermittelt; Eichsubstanzen waren Polystyrole unterschiedlicher Molmasse.

Tabelle 1 gibt eine Übersicht über die Zusammensetzung der Polymerisate I; Tabelle 2 faßt ihre anwendungstechnisch relevanten Eigenschaften zusammen.

Tabelle 1: Polymerisate I

| Polymerisat I Nr. Zusammensetzung | | I-1 | I-2 | I-3 | I-4 | I-5 | I-6 | I-7 | I-8 | I-9 | I-10 | I-11 |
|---|---|---|---|---|---|---|---|---|---|---|---|---|
| Pol | Block A: | | | | | | | | | | | |
| | Gew.-% Styrol[a] | 13 | 13 | 17 | 17 | 22 | 22 | 17 | 17 | 17 | 17 | 17 |
| | Block B: | | | | | | | | | | | |
| | Gew.-% Butadien[a] | 87 | 87 | 83 | 83 | 78 | 78 | 83 | 83 | 83 | - | 83 |
| | Gew.-% Isopren[a] | - | - | - | - | - | - | - | - | - | 83 | - |
| $R^1$ | | $-CH_2-CH_2-$ | s.v. | s.v. | s.v. | s.v. | s.v. | s.v. | s.v. | s.v. | $-CH_2-CH-$<br>\|<br>$CH_3$ | $-CH_2-CH_2-$ |
| a | | 1 | s.v. | s.v. | s.v. | s.v. | s.v. | s.v. | s.v. | s.v. | s.v. | s.v. |
| $R^2$ | | $-CH=CH-$ | s.v. | s.v. | s.v. | s.v. | s.v. | s.v. | $-CH_2-CH_2-$ | $-CH=CH-$ | s.v. | s.v. |
| $X^\ominus$ | | $-COO^\ominus$ | s.v. | s.v. | s.v. | s.v. | s.v. | s.v. | s.v. | s.v. | s.v. | s.v. |
| M | | $Li^\oplus$ | s.v. | s.v. | s.v. | s.v. | s.v. | $Zn^{2\oplus}$ | $Al^{3\oplus}$ | $Li^\oplus$ | s.v. | s.v. |
| n | | 1 | s.v. | s.v. | s.v. | s.v. | s.v. | 2 | 3 | 1 | s.v. | s.v. |

a) A + B = 100 Gew.%;
s.v. = siehe vorangehendes Beispiel;

Tabelle 2: Anwendungstechnisch relevante Eigenschaften der Polymerisate I

| Polymerisat I Nr. | | | | | | | | | | | |
|---|---|---|---|---|---|---|---|---|---|---|---|
| Eigenschaft | I-1 | I-2 | I-3 | I-4 | I-5 | I-6 | I-7 | I-8 | I-9 | I-10 | I-11 |
| Molmasse | 70.000 | 80.000 | 40.000 | 60.000 | 45.000 | 10.000 | 60.000 | 60.000 | 85.000 | 60.000 | 60.000 |
| Viskositätszahl VZ (ml/g) | 147 | 163 | 114 | 161 | 100 | 40 | 113 | 209 | 188 | 80 | 115 |
| Deformationshärte | 2750 | 4750 | 2650 | 4700 | 5200 | - | 8000 | >20000 | 5750 | 4000 | 5100 |
| Deformationselastizität | 32 | 41 | 30 | 42 | 34 | - | 45 | - | 43 | 55 | 41 |
| Shore A-Härte | 18 | 25 | 18 | 25 | 28 | fl. | 39 | 59 | 28 | 22 | 25 |

fl. = flüssig

Beispiel 1

Herstellung eines durch Photopolymerisation vernetzbaren Gemischs und von photovernetzten Folien daraus

246,80 g Polymerisat I-1 gemäß Tabelle 1, 18,70 g 1,6-Hexandioldiacrylat, 9,20 g 1,6-Hexandioldimethacrylat, 3,35 g Benzildimethylacetal und 1,39 g 2,6-Di-tert.-butyl-p-kresol wurden in 370 g Toluol bei 65°C gelöst. Ein Teil der Lösung wurde auf eine mit einem 2 µm dicken Polyamidfilm (Copolyamid aus dimeren Alkandicarbonsäuren einer Molmasse von 565 und Hexamethylendiamin) beschichtete 125 µm dicke Polyesterfolie aufgerakelt, wobei die Gießschichtdicke mit Hilfe eines Rakelgießers so eingestellt wurde, daß nach dem Abdampfen des Toluols bei 80°C ein etwa 0,7 mm dicker photovernetzbarer Film zurückblieb. Dieser Film wurde mit einer transparenten 25 µm dicken Polyethylenfolie abgedeckt und mit einem mit 40 Watt UV-Röhren bestückten Flachbelichter während 15 Minuten von der Vorder- und der Rückseite her vollflächig belichtet. Nach Entfernen der Träger- und Abdeckfolie erhielt man eine freitragende photovernetzte Folie mit einer Reißfestigkeit von 11,1 $N/mm^2$ bei einer Reißdehnung von 264 %; für 100 %ige Dehnung waren 4,6 $N/mm^2$ notwendig. Die Gewichtsquellung betrug nach 24 Stunden bei 25°C in Ethanol 0,9 %, in Wasser 0,1 % und in Ethanol/Ethylacetat (Gewichtsverhältnis 7:3) 13 %. Ihr Rückstellverhalten war sehr gut: Der Eindruck eines zylinderförmigen Stempels von 4 mm Durchmesser mit einem Auflagegewicht von 1000 g geht nach 2 Minuten Belastung in weiteren 2 Minuten Entlastung auf 1,4 % zurück.

Der ursprüngliche photovernetzbare Film zeigte bei Belastung nur eine sehr geringe Kriechneigung.

Ein weiterer Teil der Gießlösung wurde so in Rahmen gegossen, daß nach dem Abdampfen des Toluols, 7-tägiger Trocknung bei 25°C, 3-stündiger Trocknung bei 80°C und 24-stündiger Trocknung bei 50°C, 6 mm dicke photovernetzbare Filme entstanden. Diese wurden auf jeder Seite mit transparenten Folien abgedeckt und während 15 Minuten beidseitig vollflächig belichtet. Die resultierenden photovernetzten Folien besaßen eine Shore A-Härte von 55 und eine Rückprallelastizität von 67 %.

Beispiele 2 bis 6

Herstellung von durch Photopolymerisation vernetzbaren Gemischen und von photovernetzten Folien daraus

In den Beispielen 2 bis 6 wurde die in Beispiel 1 angegebene Rezeptur verwendet, nur daß anstelle des Polymerisats I-1 gemäß Tabelle 1 andere Polymerisate I verwendet wurden. Die Herstellung der Gemische, der Filme und der Folien sowie die Durchführung der Untersuchungen erfolgte wie in Beispiel 1. Die Tabelle 3 gibt eine Übersicht über die Versuchsergebnisse. Der Klarheit halber werden die Versuchsergebnisse aus Beispiel 1 mit aufgeführt.

Tabelle 3

Beispiele 2 bis 6

Versuchsergebnisse

| Beispiel Nr. | 1 | 2 | 3 | 4 | 5 | 6 |
|---|---|---|---|---|---|---|
| Polymerisat gemäß Tabelle 1 | I-1 | I-2 | I-4 | I-5 | I-8 | I-11 |
| Dünne Folie: | | | | | | |
| Dicke (mm) | 0,7 | 0,7 | 0,7 | 0,7 | 0,7 | 0,7 |
| Reißfestigkeit ($N/mm^2$) bei | 11,1 | - | 7,5 | 9,1 | 7,0 | 9,2 |
| Reißdehnung (%) | 264 | - | 267 | 303 | 24,3 | 42 |
| 100 % Dehnung bei ($N/mm^2$) | 4,6 | - | 2,6 | 3,5 | 3,4 | 1,1 |
| Gewichtsquellung (24 h, 25°): | | | | | | |
| in Ethanol (Gew.%) | 0,9 | 2,2 | - | 2,1 | 2,9 | 2,2 |
| in $H_2O$ (Gew.%) | 0,1 | 0,7 | - | - | - | 0,9 |
| in Ethanol/Ethylacetat (Gew.%) | 13 | 14 | - | 15,3 | 16,8 | 14,0 |
| Stempeleindruck: Verformungsrest (%) | 1,4 | 1,4 | 0,6 | 0,7 | 0,5 | 0,6 |
| Dicke Folie: | | | | | | |
| Dicke (mm) | 6 | 6 | 5 | 5 | 5 | 5 |
| Rückprallelastizität (%) | 67 | 74 | 66 | 54 | 59 | 46 |
| Shore A-Härte | 55 | - | 65 | 68 | 74 | 46 |
| Kriechneigung der photovernetzbaren Filme unter Belastung | sehr gering | sehr gering | sehr gering | sehr gering | sehr gering | sehr gering |

Beispiel 7

Herstellung eines durch Photopolymerisation vernetzbaren Gemischs und von photovernetzten Folien daraus

Aus 156,60 g Polymerisat I-3 gemäß Tabelle 1, 13,40 g 1,6-Hexandioldiacrylat, 6,60 g 1,6-Hexandioldimethacrylat, 2,40 g Benzildimethylacetal, 1,00 g 2,6-Di-tert.-butyl-p-kresol, 12 mg Sudantiefschwarz (C.I. 26150), 10,00 g Paraffinöl (medizinisches Weißöl, aromatenfrei, Viskosität (25°C) = 140 mPas, Stockpunkt = -9°C, Dichte (15°C) = 0,865 g/$cm^3$), 10,00 g eines p-Methylstyrol-α-Methylstyrol-Copolymerisats (Erweichungspunkt Ep. = 95-110°C, Brechungsindex (25°C) = 1,58, Schmelzviskosität (130°C) = 1 Pas) und 200 g Toluol wurde eine Gießlösung und aus dieser nach Beispiel 1 in einem Gießrahmen eine 5,7 mm dicke photovernetzte Folie hergestellt. Sie wies eine Shore A-Härte von 55 und eine Rückprallelastizität von 62 % auf. Desweiteren wurde gemäß Beispiel 1 aus dem Gemisch eine 0,7 mm dicke Folie hergestellt und ihr Verformungsrest wie in Beispiel 1 gemessen. Er betrug 1,4 %.

Beispiel 8

Herstellung eines durch Photopolymerisation vernetzbaren Gemischs und von photovernetzten Folien daraus

Es wurde ein Gemisch durch Extrusion von 25,00 kg granuliertem Polymerisat I-4 gemäß Tabelle 1, 1,50 kg Paraffinöl gemäß Beispiel 7, 1,01 kg 1,6-Hexandioldiacrylat, 0,49 kg 1,6-Hexandioldimethacrylat, 1,50 kg p-Methylstyrol-α-Methylstyrol-Copolymerisat gemäß Beispiel 7, 0,36 kg Benzildimethylacetal, 0,15 kg 2,6-Di-tert.-butyl-p-kresol und 1,8 kg Sudantiefschwarz (C.I. 26150) in einem Zweischneckenextruder hergestellt. Dazu wurden die flüssigen Bestandteile (Paraffinöl und Monomere) mit Farbstoff, Stabilisator und Photoinitiator vermischt, in den Mischextruder eingespritzt, bei 136°C mit den thermoplastischen Komponenten vermischt und das resultierende Gemisch bei 150°C über eine Breitschlitzdüse ausgetragen. Mit Hilfe eines Kalanders wurde das ausgetragene Gemisch mit der einen Seite auf eine mit einer 5 µm dicken Phenoxiharz/Polycarbonat-Haftlackschicht bedeckten, 125 µm dicken Polyethylenterephthalatfolie laminiert und auf der anderen Seite mit einer Polyamid-beschichteten Polyethylenterephthalatfolie gemäß Beispiel 1 bedeckt und das Mehrschichtenelement auf eine Gesamtschichtdicke von 3,01 mm gebracht.

Ein Teil des extrudierten Gemisches wurde ohne Kalandrierung ausgetragen und für die Herstellung einer 0,7 mm und einer 5,7 mm dicken Folie gemäß Beispiel 1 verwendet. Die dicke Folie besaß eine Shore A-Härte von 55 und eine Rückprallelastizität von 62 %, die dünne Folie wies nach der Stempeleindruckprüfung gemäß Beispiel 1 einen Verformungsrest von 1,4 % auf.

Beispiel 9

Herstellung eines durch Photopolymerisation vernetzbaren Gemischs und von photovernetzten Folien daraus

Es wurde wie in Beispiel 8 verfahren, nur daß anstelle des Polymerisats I-4 das Polymerisat I-7 verwendet wurde. Der photovernetzbare Film besaß eine äußerst geringe Kriechneigung.

Eine nach Beispiel 1 aus dem Gemisch hergestellte, 5,7 mm dicke photovernetzte Folie wies eine Shore A-Härte von 59 und eine Rückprallelastizität von 61 % auf.

Beispiel 10

Herstellung eines durch Photopolymerisation vernetzbaren Gemischs und von photovernetzten Folien daraus

Aus einem Gemisch gemäß Beispiel 8, bei dem anstelle des Polymerisats I-4 das Polymerisat I-8 verwendet wurde, wurde gemäß Beispiel 1 eine Gießlösung in Toluol hergestellt und in entsprechender Weise zu 5 mm dicken photovernetzten Folien verarbeitet.

Die Shore A-Härte des 5 mm dicken Films betrug 74, ihre Rückprallelastizität 59 %. Nach der Stempeleindruckprüfung gemäß Beispiel 1 verblieb ein Verformungsrest von 0,5 %.

Beispiel 11

Herstellung eines flüssigen, durch Photopolymerisation vernetzbaren Gemischs und seine Verwendung als Lackschicht

156,00 g Polymerisat I-6 gemäß Tabelle 1, 30,00 g 1,6-Hexandioldimethacrylat, 1,00 g 2,6-Di-tert.-butyl-p-kresol und 2,40 g Benzildimethylacetal wurden bei 60°C homogen miteinander vermischt. Es wurden

Proben entnommen und auf Glas-, Metall- und Kunststoffplatten ausgegossen. Die resultierenden Lackfilme wurden mit Polyethylenfolien abgedeckt und während 30 Minuten durch die Deckfolien hindurch vollflächig belichtet. Nach Abziehen der Deckfolien wurden transparente Lackschichten einer Shore A-Härte von 25 erhalten.

Beispiel 12

Herstellung eines durch Photopolymerisation vernetzbaren Gemischs und seine Verwendung als lichthärtbarer Kleber

100 g Polymerisat I-4 gemäß Tabelle 1, 80 g Piperylen-2-Methylbuten-2-Copolymerisat (Wingtack 95® von der Fa. Goodyear), 20 g 1,1,1-Trimethylolpropantrimethacrylat, 1,5 g 2,6-Di-tert.-butyl-p-kresol und 3 g Benzildimethylacetal wurden in 160 g Cyclohexan bei 60°C gelöst. Eine Probe dieser Lösung wurde auf eine Polyethylenterephthalatfolie aufgestrichen und das Lösungsmittel bei 50°C verdampft. Auf die resultierende trockene, lichthärtbare Klebschicht laminierte man eine weitere Polyethylenterephthalatfolie und belichtete während 2 Minuten vollflächig. Die Adhäsion des lichtgehärteten Klebers an die beiden Folien war ausgezeichnet; sie konnten nicht mehr voneinander getrennt werden, ohne den gesamten Verbund zu beschädigen.

Beispiele 13 und 14

Herstellung von durch Photopolymerisation vernetzbaren Gemischen und die Ozonstabilität der daraus hergestellten photovernetzten Folien

Es wurden wie in Beispiel 8 Bahnen 2,84 mm dicker Mehrschichtenelemente extrudiert und kalandriert, nur daß anstelle der haftlackbeschichteten Polyethylenterephthalat-Trägerfolien Polyamid-beschichtete gemäß Beispiel 1 verwendet wurden, und daß in Beispiel 14 anstelle des Polymerisats I-4 das Polymerisat I-10 gemäß Tabelle 1 zur Anwendung kam.

Von den Filmbahnen wurden Proben abgetrennt, die während jeweils 15 Minuten beidseitig vollflächig belichtet wurden. Nach Abziehen der Deck- und Trägerfolien wurden die mechanischen Werte bestimmt; eine Zusammenfassung findet sich in der Tabelle 4.

Tabelle 4: Mechanische Werte photovernetzter Folien

| Beispiel Nr. | 13 | 14 |
|---|---|---|
| Shore A-Härte | 55 | 44 |
| Rückprallelastizität (%) | 62 | 61 |
| Stempeleindruckprüfung gem. Beispiel 1: | | |
| Verformungsrest (%) | 1,4 | 8 |

Die Prüfung der Stabilität gegenüber Ozon wurde wie folgt durchgeführt:
2 cm breite Probestreifen aus den Bahnen wurden jeweils 10 Minuten lang einseitig belichtet, während 6 Minuten mit einem Gemisch aus Tetrachlorethylen und n-Butanol (Volumenverhältnis = 4:1) behandelt, während 1 Stunde bei 80°C getrocknet, 15 Stunden lang bei Raumtemperatur gelagert, während 5 Minuten mit einer 0,4 %igen wäßrigen Bromlösung nachbehandelt und während 10 Minuten nachbelichtet. Die so hergestellten Folienstücke konnten demnach als Modelle für Flexodruckformen angesehen werden.

Die Folienstücke wurden in einer Ozonkammer bei 24°C einer Luft mit einem Ozongehalt von 50 pphm ausgesetzt. Bei Folienstücken gemäß Beispiel 13 zeigten sich erste Ozonrisse nach 150 Minuten; bei solchen gemäß Beispiel 14 nach 30 Minuten. Demnach besitzen nur Folienstücke gemäß Beispiel 13 - ohne Verwendung von Antiozonantien - befriedigende Ozonstabilität.

Beispiel 15

Herstellung eines durch Photopolymerisation vernetzbaren Gemischs und von Druckformen daraus

Aus einem Gemisch nach Beispiel 1, das zusätzlich noch 2,4 mg Sudantiefschwarz (C.I. 26150) enthielt, wurde, wie in Beispiel 1 beschrieben, eine 0,7 mm dicke reliefbildende Schicht "RS" auf einer Polyamid-beschichteten Polyethylenterephthalatfolie erzeugt. Dieses Mehrschichtenelement wurde mit Hilfe von Kaschierwalzen mit der freien Oberfläche von "RS" auf eine mit einem Phenoxiharz/Polycarbonat-Haftlack beschichtete, 125 µm dicke Polyesterfolie laminiert. Der Haftlack enthielt als Lichthofschutzmittel ein Gemisch aus einem gelben Auraminfarbstoff (Auramin FA, Basic Yellow 2, C.I. 41000) und 4,4'-Bis-(N-β-hydroxyethyl-N-methylamino)-benzophenon in einem Gewichtsverhältnis von 4:1 und einer Extinktion von 0,40 bei einer Wellenlänge von $\lambda$ = 360 nm. Nach dem Auflaminieren wurde die ursprüngliche Trägerfolie abgezogen, wobei die Polyamidschicht auf "RS" verblieb. Auf die mit Polyamid beschichtete Seite von "RS" wurde ein photographisches Testnegativ aufgelegt und "RS" während 10 Minuten mit Hilfe eines Flachbelichters bildmäßig belichtet. Anschließend wurde das belichtete Mehrschichtenelement in einem Bürstenwascher mit einem Gemisch aus 3 Volumenteilen Tetrachlorethylen und 1 Volumenteil n-Butanol entwickelt, mit einer 0,4 %igen Bromlösung während 3 Minuten nachbehandelt, getrocknet und während 10 Minuten vollflächig nachbelichtet. Man erhielt eine Flexodruckform mit sauber ausgebildetem Relief, das scharfe Kanten und gute Zwischentiefen in den gerasterten Halbtonflächen zeigte. Beim Drucken auf einem Flexodruckwerk mit einer Ethanolfarbe erhielt man ausgezeichnete Druckergebnisse. Die Druckform zeigte selbst nach mehrstündigem Druck keinerlei Abrieb, Risse oder Deformationen.

Beispiel 16

Herstellung eines durch Photopolymerisation vernetzbaren Gemischs und von Druckformen daraus

Mit Hilfe der Gießlösung gemäß Beispiel 7 wurde gemäß Beispiel 1 ein Mehrschichtenelement, bestehend aus einer 125 µm dicken Polyethylenterephthalatfolie, einer 2 µm dicken Polyamid-Zwischenschicht und einer 0,7 mm dicken reliefbildenden Schicht "RS" hergestellt und zur weiteren Verwendung aufbewahrt.

Eine 75 µm dicke Polyethylenterephthalatfolie wurde beidseitig mit einem Phenoxiharz/Polycarbonat-Haftlack in 5 µm Dicke beschichtet und zur weiteren Verwendung aufbewahrt. Die später "RS" zugekehrte Haftlackschicht enthielt ein Lichthofschutzmittel nach Beispiel 15.

Zur Herstellung einer Trägerschicht gemäß DE-OS 24 44 118 wurden 196,00 g Polymerisat I-9 gemäß Tabelle 1, 75,00 g eines flüssigen Polybutadiens (Molmasse 1300, Viskosität (25°C) = 7 Pas, Gehalt am 1,2-Struktureinheiten ca. 40 Gew.%, Dichte = 0,89 g/cm$^3$), 3,60 g Benzildimethylacetal, 24,00 g 1,6-Hexandioldimethacrylat und 1,50 g 2,6-Di-tert.-butyl-p-kresol in 250 g Toluol gelöst und gemäß Beispiel 1 auf eine Polyamid-beschichtete Polyethylenterephthalatfolie so aufgegossen, daß nach dem Trocknen ein photovernetzbarer Film von 1,00 mm Stärke verblieb. (Eine Probe von diesem Mehrschichtenelement wurde vollflächig belichtet; die photovernetzte Folie besaß eine Shore A-Härte von 39 und eine Rückprallelastizität von 60 %). Auf die freie Oberfläche dieses Films wurde in einem Kalanderwerk die Haftlack-beschichtete Polyethylenterephthalatfolie aufgewalzt, wobei diejenige Haftlackschicht, die keine Lichthofschutzmittel enthielt, mit dem Film verbunden wurde. Das resultierende Mehrschichtenelement wurde beidseitig während 15 Minuten vollflächig mit 40 Watt UV-Röhren belichtet, anschließend wurde die freie Haftlackschicht des belichteten Mehrschichtenelements mit der freien Oberfläche von "RS" des anfangs hergestellten Mehrschichtenelements durch Laminieren verbunden.

Dieses Mehrschichtenelement wurde während 12 Minuten von der Trägerseite her vollflächig vorbelichtet. Dann wurde gemäß Beispiel 15 die obere Polyethylenterephthalatfolie von "RS" abgezogen, letztere durch eine aufgelegte Testnegativvorlage hindurch bildmäßig belichtet und entwickelt. Druckversuche in einem Flexodruckwerk mit dieser Druckform ergaben eine Auflagenfestigkeit von über 100.000 Auflagen bei sehr guter Bildwiedergabe.

Beispiel 17

Herstellung eines durch Photopolymerisation vernetzbaren Gemischs und von Druckformen daraus

Das gemäß Beispiel 8 hergestellte, 3,01 mm dicke Mehrschichtenelement wurde in Flexodruckplatten handelsüblicher Größe (0,6 × 0,32 m) zurechtgeschnitten. Eine solche Flexodruckplatte wurde während 1 Minute von der Trägerseite her vollflächig vorbelichtet. Anschließend zog man die Deckfolie ab, wobei die Polyamid-Schicht auf "RS" verblieb, belichtete "RS" durch eine auf die Polyamid-Schicht aufgelegte Testnegativvorlage hindurch während 14 Minuten, entwickelte gemäß Beispiel 15 in einem Bürstenwascher, trocknete die erhaltene Flexodruckform während 1 Stunde bei 80°C und lagerte sie 15 Stunden lang bei Raumtemperatur. Danach wurde die Druckform während 3 Minuten in üblicher Weise bromiert, erneut getrocknet und während 10 Minuten vollflächig nachbelichtet.

Die in dieser Weise hergestellte Flexodruckform bzw. ihre Reliefschicht besaß eine Relieftiefe von 800 µm mit sehr gutem Flankenaufbau und exakter Randschärfe. Druckversuche auf einem Flexodruckwerk mit dieser Druckform lieferten Druckergebnisse mit sehr exakter Bildwiedergabe.

**Patentansprüche**

1. Durch Photopolymerisation vernetzbare Gemische auf der Grundlage von Bindemitteln, hiermit verträglichen photopolymerisierbaren Monomeren, Photoinitiatoren und Inhibitoren gegen die thermisch initiierte Polymerisation, enthaltend als Bindemittel Polymerisate der Formel I

$$[\mathrm{Pol}\!-\!(R^1-O)_a\!-\!\overset{\overset{\displaystyle O}{\|}}{C}-R^2-X^{\ominus}]_n\;[M]^{n\oplus} \qquad \mathrm{I}$$

worin die Variablen und die Indices folgende Bedeutungen haben:
Pol Rest eines durch sequentielle anionische Polymerisation von konjugierten Dienen und Vinylaromaten hergestellten Blockcopolymerisates,
$R^1$ vicinale Alkan-diyl-Gruppe,
$R^2$ zweiwertige Kohlenwasserstoffgruppe mit 2 bis 20 Kohlenstoffatomen,
$X^{\ominus}$ Säureanion-Gruppe,
M Metallkation, Metallkationenkomplex oder Kation eines Amins und
a eine ganze Zahl von 1 bis 10 und
n eine ganze Zahl von 1 bis 10.

2. Gemische nach Anspruch 1, worin $R^2$ eine Ethylen-, Trimethylen-, Propen-2,3-diyl-, Buta-1,3-dien-2,3-diyl-, Cyclohex-1,2-ylen-, Cyclohexa-3-en-1,6-ylen-, Cyclopent-1,2-ylen-, o-Phenylen- oder eine Naphth-1,8-diyl-Gruppe darstellt.

3. Verwendung der Gemische gemäß den Ansprüchen 1 und 2 für die Herstellung von Druckplatten, Reliefplatten und photovernetzbaren Filmen.

4. Verwendung der Gemische gemäß den Ansprüchen 1 und 2 für die Herstellung von lichthärtbaren Klebern, Dichtungsmassen und Lacken.

5. Verwendung der Gemische gemäß den Ansprüchen 1 und 2 für die Herstellung von Druckformen, Reliefformen und photovernetzten Folien.

6. Druckplatten, Reliefplatten und photovernetzbare Filme, hergestellt aus Gemischen gemäß den Ansprüchen 1 und 2.

7. Lichthärtbare Kleber, Dichtungsmassen und Lacke, hergestellt aus Gemischen gemäß den Ansprüchen 1 und 2.

8. Druckformen, Reliefformen und photovernetzte Folien, hergestellt aus Gemischen gemäß den Ansprüchen 1 und 2.

## Claims

1. A mixture which can be crosslinked by photopolymerization, is based on binders, photopolymerizable monomers which are compatible with these, photoinitiators and thermal polymerization inhibitors, and contains, as the binder, polymers of the formula I

$$[\mathrm{Pol}\!-\!(R^1-O)_a\!-\!\overset{\overset{\displaystyle O}{\|}}{C}-R^2-X^{\ominus}]_n\;[M]^{n\oplus} \qquad \mathrm{I}$$

where
Pol is a radical of a block copolymer prepared by sequential anionic polymerization of conjugated dienes and vinyl aromatics,
$R^1$ is a vicinal alkanediyl group,
$R^2$ is a divalent hydrocarbon group of 2 to 20 carbon atoms,
$X^{\ominus}$ is an acid anion,
M is a metal cation, a metal cation complex or a cation of an amine, and
a and n are each an integer from 1 to 10.

2. A mixture as claimed in claim 1, wherein $R^2$ is ethylene, trimethylene, propene-2,3-diyl, buta-1,3-diene-2,3-diyl, cyclohex-1,2-ylene, cyclohex-3-en-1,6-ylene, cyclopent-1,2-ylene, o-phenylene or naphthalene-1,8-diyl.

3. The use of a mixture as claimed in claims 1 and 2 for producing a printing plate, relief plate or photocrosslinkable film.

4. The use of a mixture as claimed in claims 1 and 2 for producing a photocurable adhesive, sealing material or surface coating.

5. The use of a mixture as claimed in claims 1 and 2 for producing a printing form, relief form ore photocrosslinked film.

6. A printing plate, relief plate or photocrosslinkable film produced from a mixture as claimed in claims 1 and 2.

7. A photocurable adhesive, sealing material or surface coating produced from a mixture as claimed in claims 1 and 2.

8. A printing form, relief form or photocrosslinked film produced from a mixture as claimed in claims 1 and 2.

**Revendications**

1. Mélanges réticulables par photopolymérisation, à base de liants, de monomères photopolymérisables compatibles avec eux, de photoinitiateurs et inhibiteurs de la polymérisation initiée thermiquement, contenant comme liants des polymérisats de la formule

$$[Pol\!-\!(R^1 - O -)_a \overset{O}{\overset{\|}{C}} - R^2 - X^{\ominus}]_n \; [M]^{n\oplus} \qquad I$$

où les variables et les indices ont les significations suivantes:
Pol, reste d'un copolymérisat en bloc préparé par polymérisation anionique séquentielle de diènes conjugées et d'aromates vinyliques
$R^1$, groupe alcane-diyle vicinal
$R^2$, groupe d'hydrocarbures bivalents de 2 à 20 atomes de carbone
$X^{\ominus}$ , groupe anion d'acide
M, cation de métal, complexe de cation de métal ou cation d'une amine et
a, un nombre de 1 à 10 et
n, un nombre de 1 à 10.

2. Mélanges selon la revendication 1, dans lesquels $R^2$ représente un groupe éthylène, triméthylène, propen-2,3-diyle, buta-1,3-dien-2,3-diyle, cyclohex-1,2-ylène, cyclohexa-3-en-1,6-ylène, cyclopent-1,2-ylène, o-phénylène ou napht-1,8-diyle.

3. Utilisation des mélanges selon les revendications 1 et 2 pour la fabrication de clichés offset, clichés relief et films photoréticulables.

4. Utilisation des mélanges selon les revendications 1 et 2, pour la fabrication d'adhésifs durcissables à la lumière, de masses d'étanchéité et de peintures et vernis.

5. Utilisation des mélanges selon les revendications 1 et 2 pour la fabrication de formes d'impression, forme en relief et feuilles photoréticulables.

6. Clichés offset, clichés en relief et films photoréticulables fabriqués à partir de mélanges selon l'une des revendications 1 et 2.

7. Adhésif durcissable à la lumière, masses d'étanchéité et peintures et vernis, fabriqués à partir de mélanges selon les revendications 1 et 2.

8. Formes d'impression, formes en relief et feuilles photoréticulables fabriquées à partir de mélanges selon les revendications 1 et 2.